# EUROPEAN PATENT APPLICATION

(11) **EP 1 659 628 A1**
(43) Date of publication of application: **24.05.2006**
(21) Application number: 04027764.2
(22) Date of filing: 23.11.2004
(51) Int. Cl.: H01L 23/495

(54) **High lead density electronic device**

(71) Applicant: Optium Care International Tech. Inc., 114 Taipei City (TW)
(72) Inventor: Lien, Jeffrey, Shihlin District, Taipei City 111 (TW)
(74) Representative: Appelt, Christian W.

(57) **Abstract**

A high density lead arrangement package structure is disclosed, it is related an improvement on traditional leadframe staggered arranged leads, the leadframe contains multiple rows arrangement of block leads, at least one conducting surface is formed at the bottom side of leads, the conducting surface of leads is specifically selected and installed with at least one insulator, the insulator on the leads are arranged in spaced and staggered way such that the exposed conducting surface of neighboring insulators is arranged in spaced and staggered way too, leads which are arranged in high density way and easily to be manufactured are thus formed.

## Description

### BACKGROUND OF THE INVENTION

### 1.Field of the Invention:

This invention is related to a high density lead arrangement package structure, it is more specifically related to lead arrangement improvement for leadframe which is used to carry chip and to be electrically connected to outside, leads thus formed can be arranged in high density way and are easy to be manufactured.

### 2.Description of the Related Art:

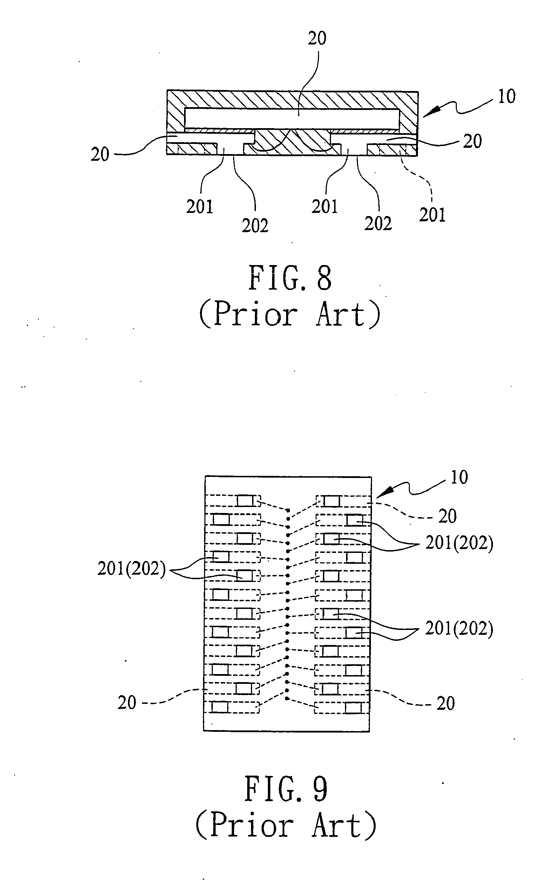

The design and development trend for electronic products nowadays has moved toward multi-function, high capacity (high memory capacity), high transfer speed and miniaturization. There are few products with single unique function, relatively, internal functional transistors of electronic product has been requested to be of smaller size and possessing more and finer lead counts to be connected to printed circuit board such that high speed and massive amount of data output or record can be satisfied for the requirement of information transfer nowadays. As shown in figure 8 and figure 9, because the lead 20 of leadframe 10 which carries chip 30 must have multiple lead count and high density structure, two leads 20 thus are easily in contact of each other due to solder spreading. Therefore, the leads 20 of leadframe 10 is commonly manufactured by pressing machine to make a protruding part 201 on the bottom of lead 20, the conduction surface 202 on the bottom of protruding part 201 is then used to be connected to printed circuit board, another neighboring lead 20 has its protruding part 201 arranged in a staggered location, such staggered arrangement is used to prevent solder getting in contact with each other.

But the commonly seen protruding part 201 of lead 20 of leadframe 10 is made and formed by pressing operation through a mold, under the strict requirement of staggered arrangement of protruding part 201, not only the mold turn out to be very difficult to be manufactured (especially during the pressing operation of needle-like leads 20), but also the leadframe 10 cost can not be reduced, in addition, defects easily appear during pressing operation, all these make quality control cost increased and affect the packaged transistor yield rate.

### SUMMARY OF THE INVENTION

The main purpose of this invention is to provide a high density lead arrangement package structure design, it is specifically related to an improvement on leadframe lead structure which is used to carry a chip and to be electrically connected to outside, the leads thus formed can be easily arranged in high density staggered structure and can be easily manufactured to further reduce quality control cost.

According to the above-mentioned purposes, the embodiment of the current invention is to let leadframe to have multiple rows arrangement of block leads, the bottom surface of leads is used to be electrically connected to outside, the conducting surface of each selected lead contains at least one insulator, the insulators on the leads are arranged in spaced ad staggered way, the exposed conducting surface of neighboring insulators is arranged in spaced and staggered way too, leads which are arranged in high density way and easily to be manufactured are thus formed; the connecting points on printed circuit board could also be installed with spaced and staggered arranged insulators as mentioned above, therefore, leads with staggered arrangement structure are fulfilled.

### BRIEF DESCRIPTIONS OF THE DRAWINGS

Figure 1 is the cross section view of rectangular block leads installed with insulator for the current invention.
Figure 2 is the bottom view of leads installed with insulator to form exposed conducting surface which is arranged in staggered way for the current invention.
Figure 3 is the embodiment cross section view of leads installed with protruding part and insulator for the current invention.
Figure 4 is another embodiment cross section view of leads installed with protruding part and insulator for the current invention.
Figure 5 is another embodiment cross section view of leads installed with two protruding parts and insulator for the current invention.
Figure 6 is embodiment of current invention where encapsulated body is used to form insulator.
Figure 7 is embodiment of current invention where encapsulated body is used in four rows of leads.
Figure 8 is the cross section view of prior art where leads are arranged in staggered way.
Figure 9 is the bottom view of prior art where leads are arranged in staggered way.

### DETAILED DESCRIEPTION OF THE PREFERRED EMBODIMENT

The features and other functions and purposes of this invention are described in the followings according to the embodiments in attached figures:

As shown in the attached figures ,this invention is related to "high density lead arrangement package structure" design, it is to provide package structure improvement on leads 11 of leadframe 1 which is to provide a carrier for chip 3 and to provide a way to be electrically connected to outside,the better embodiments comprising:

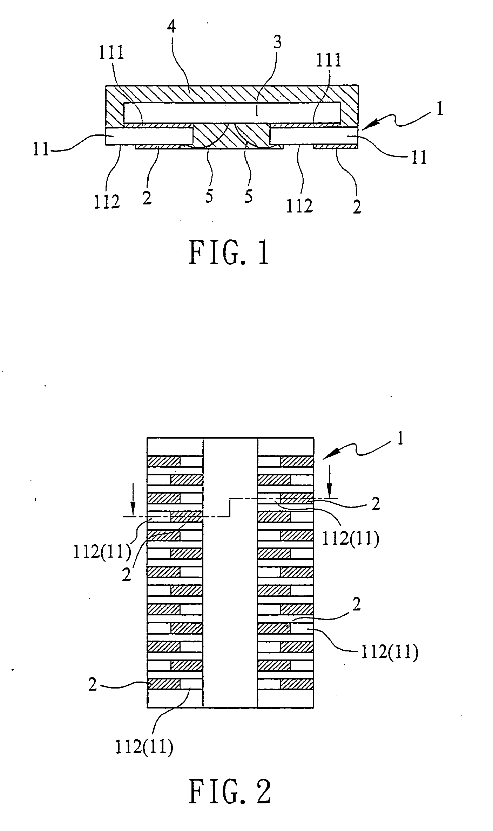

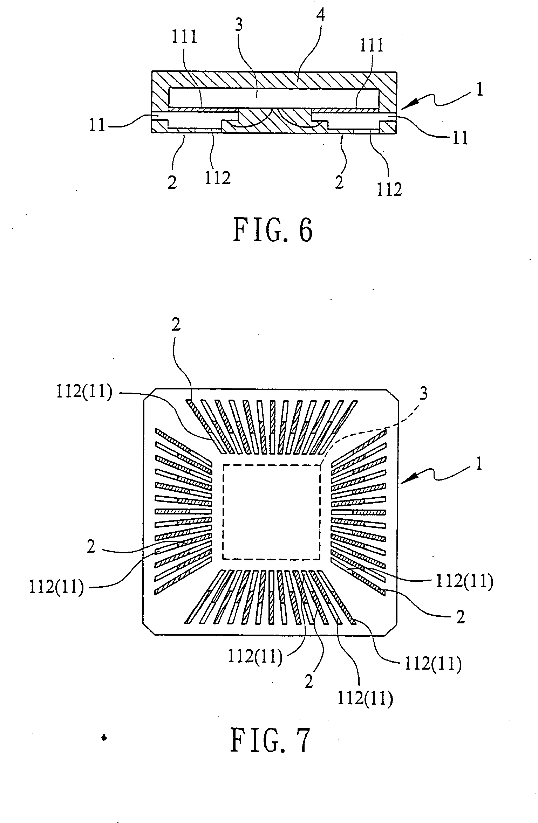

Leadframe 1 containing multiple rectangular block shape and multiple rows arrangement of metallic leads 11 structure according to the requirement from chip 3 or outer electrical device (for example, the rows arrangement connecting points and number of connecting points in printed circuit board), let the block leads 11 contain on its upper part at least one chip 3 carrier surface 111 and a conducting surface 112 on its lower part surface used to be electrically connected to outside; the number of arrangement and status of arrangement are as shown in figure 2 and figure 7, it can be divided into two rows, four rows or other number of rows, it can also be in parallel or radiating or regular or irregular way of arrangements; leads 11 are arranged n rows and forms leadframe 1, it could be made of metallic material and carries chip 3 directly, encapsulated body 4 is used to package and the packaged leadframe is diced later on such that leads 11 form independent and fixed leadframe 1 which can be electrically connected to outside; furthermore leads 11 which are made up of metallic material can be first fixed by encapsulant and diced (that is , it is encapsulated to fix leads 11 before chip 3 is attached to it), an independent structure of leadframe 1 which can be used to carry chip 3 is thus formed;

This invention chooses leadframe 1 which either carries chip 3 but before packaging or carries chip 3 but after packaging , and selects to install at least one insulator 2 which is made of insulating materials on specifically the lower part conducting surface 112 of leads 11 (as shown in figure 1), insulator 2 is used to shield part of the conducting surface 112 of lead 11, (the insulator 2 could be formed of any shape), let the insulator 2 of leads 11 be arranged in spaced staggered way (as shown in figure 2) and the neighboring exposed conducting surface 112 of each insulator 2 be arranged in spaced staggered way too , a structure of high density lead arrangement leads 11 with staggered and exposed conducting surface 112 is thus formed for the current invention ,the high density lead arrangement of leads 11 can thus prevent the spreading of neighbor solder.

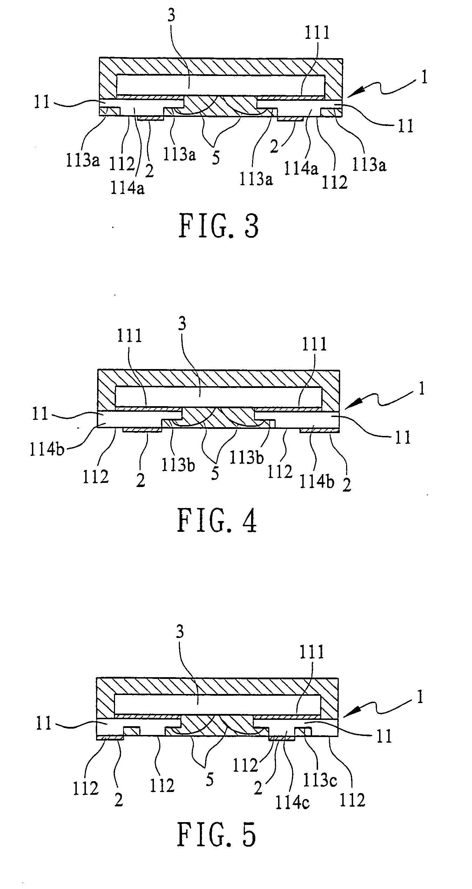

As mentioned above, the bottom surface of leads 11 is installed with insulator 2 to form staggered and exposed conducting surface 112, the structure of leads 11 is not limited to be of rectangular shape, as shown in figure 3 and figure 4, it could also be that the inner side or outer side or inner side alone of block leads 11 forms a dented surface 113a, 113b, the dented surface 113a, 113b is used for the connection site of extended metallic conducting wire 5 of chip 3, furthermore protruding parts 114a, 114b and their bottom conducting surface 112 are formed at the neighborhood of dented surfaces 113a and 113 b, the above-mentioned staggered arranged insulator 2 is further formed on the conducting surface 112 such that staggered arranged and exposed conducting surfaces 112 are formed. Or as shown in figure 5, a dented surface 113c can be formed in the inner side or close to the middle side of block leads 11 such that two spaced protruding parts 114c and their bottom conducting surfaces 112 are formed, the conducting surface 112 of one of the protruding part 114 is installed with the mentioned staggered arranged insulator 2, let the conducting surface 112 of another protruding part 114 be exposed and staggered arranged such that solder spreading among leads 11 can be prevented; therefore , the leads structure of the current invention is not specifically limited , any structure or shape of leads 11 which use bottom surface as connecting point to outside can be embodied with insulator 2 to shield part of the bottom surface.

Furthermore, the method of forming at least one insulator 2 on the conducting surface 112 of leads 11 of leadframe 1 can be done either before chip 3 is attached to leadframe 1 or after chip 3 is attached to leadfarme 1 and packaged, an insulating film can be used or potting compound can be u sed to form insulator 2, or please refer to figure 6, encapsulated body 4 which is used to package chip 3 or leadframe 1 can be used to be extended to the conducting surface 112 of leads 11 such that a structure where part of the conducting surface 112 is shielded by insulator 2 is formed, a status which other conducting surfaces 112 are exposed and arranged in staggered way is thus formed; therefore, any embodiments which paste or fix insulator to the bottom conducting surface 112 of leads 11 to shield part of the conducting surface 112 are all within the scope of staggered arranged insulator 2 arrangement of the current invention.

The structure of using insulator 2 mentioned in this invention to shield part of the conducting surface 112 of leads 11 of leadframe 1 will have the rest of conducting surfaces 112 exposed and arranged in staggered way such that the conducting solder getting in contact with each other due to solder spreading during assembly process can be prevented, therefore, higher density of leads 11 can be installed in leadframe 1 to be used as connection points to chip 3, and the requirements of multi-function, high capacity(high memory capacity), high transfer speed and miniaturization for electronic product nowadays can thus be satisfied Moreover, the embodiment of staggered insulator 2 arrangement for the current invention is much easier and convenient than that of the prior art where the staggered protruding parts 201 of leads 20 are formed by pressing operation, current invention can also avoid the technical difficulty of manufacturing staggered arranged protruding parts 201 by direct pressing operation ,the mold set cost and pressing operation cost can therefore be reduced ,more delicate embodiment of staggered arrangement of conducting surfaces 112 is easily achieved in the current invention ,quality control, chip package yield rate and stability can thus be greatly improved. Furthermore, the conducting surface 112 can be designed to be a little bit larger, and by controlling the shield area size of insulator 2 according to the connection points size and location in the printed circuit board, higher flexibility on the specs of the exposed and staggered arranged conducting surface 112 can thus be achieved, it can be fully adapted to outer device such printed circuit board.

Summarize the above descriptions, current invention of "High density lead arrangement package structure" does possess the required properties of utility and invention, its embodiments are also inventive, we therefore submit a patent application.

## Claims

1. A high density lead arrangement package structure, comprising :
providing a leadframe as an object to carry chip and to be electrically connected outside, said leadframe containing multiple blocks and rows arrangement lead structure, said block leads possessing an lower side surface to be used as a conducting surface and further to be electrically connected to outside;
selecting conducting surface to be installed with at least an insulator to shield part of said conducting surface, let said insulator of the leads be arranged in spaced and staggered way such that insulator's neighboring exposed conducting surface is also arranged in spaced and staggered way; therefore , leads with staggered arranged and exposed conducting surface structure are fulfilled.

2. The high density lead arrangement package structure of claim 1 wherein said lead contains the rectangular shape.

3. The high density lead arrangement package structure of claim 1 wherein said lead containing on its lower side at least a dented surface, forming to the neighborhood of said dented surface a protruding part and a conducting surface at the bottom surface of said protruding part.

4. The high density lead arrangement package structure of claim 1 wherein said lead dented surfaces are formed respectively at the inner side and at close to the middle of the lead such that two separate protruding parts and conducting surfaces on the protruding parts bottom are formed.

5. The high density lead arrangement package structure of claim 4 wherein said lead has one of its protruding parts' conducting surface installed with shield insulator.

6. The high density lead arrangement package structure of claim 1 wherein said insulator is formed by pasting an insulating film, solidifying potting compound or is composed of encapsulated body.

7. The high density lead arrangement package structure of claim 1 wherein said insulator can be packaged before or after chip is attached to the leadframe.
